# EUROPEAN PATENT APPLICATION

(11) **EP 0 708 529 A2**
(43) Date of publication of application: **24.04.1996**
(21) Application number: 95307290.7
(22) Date of filing: 13.10.1995
(51) Int. Cl.: H03K 17/567

(54) **Power switch driver arrangements**

(30) Priority: 21.10.1994 GB 9421402
(71) Applicant: PLESSEY SEMICONDUCTORS LIMITED, Swindon, Wiltshire SN2 2QW (GB)
(72) Inventor: Gilbert, David Peter, Lincoln, LN6 0LN (GB); Williams, Barry W., Collinton, Edinburgh, EH13 0HD (GB)
(74) Representative: Hoste, Colin Francis

(57) **Abstract**

In a semiconductor power switch driver circuit in which control signals for the power switch are applied by way of an isolating device such as a transformer or an optocoupler, faults which may occur at the power switch are arranged to be coded and signalled to the control circuitry by way of the isolating device or another such isolating device. Those faults which can occur may be assigned an order of priority, and if more than one fault is detected only the fault with the highest priority may be signalled.

## Description

The present invention relates to driver arrangements for power switches, such as insulated gate bipolar transistors (IGBTs), when such switches are utilised to control the application of high voltages to loads.

When driving a semiconductor power switch device in, say, a bridge configuration it is necessary to provide a means of electrical isolation between the gate or base electrode of the switch (which may be at a potential of hundreds of volts) and the low voltage control electronics which is provided to turn the device on and off.

This isolation is typically achieved using a semiconductor modulation device, herein referred to as the transmitter, in conjunction with an isolation device such as a pulse transformer, optocoupler or similar. Most schemes also include a second semiconductor device, herein referred to as the receiver, to demodulate the signals.

It is normal practice with such schemes to provide a return signal which serves to notify the transmitter in the event of a fault detected within the receiver or the power switch itself. This return signal is also sent by way of an isolation barrier and may be used to disable the control electronics in the event of a fault. In such cases the absence of the return signal may be used to activate a single 'Fault' output from the transmitter, but no identification of the nature of the fault is possible.

It is an object of the present invention to provide means by which the nature of the fault may be identified to the control electronics, without the need of additional isolation devices, such that appropriate action may be taken in response to the fault.

According to the present invention in a semiconductor power switch driver circuit arrangement in which a signal from a control circuit is arranged to be applied by way of isolation means to control the operation of a semiconductor power switch, and in which a return or feedback signal from said switch is arranged to be applied to said control circuit by way of said isolation means, there are provided means which are associated with said switch and which are responsive to the occurrence of any one of a plurality of possible faults in the control or operation of said switch to identify said one of said plurality of faults with a respective one of a predetermined set of codes and to modulate said return signal such as to signal said respective one of said set of codes to said control circuit.

The isolation means may comprise a pulse transformer or optocoupler link. The modulation of said return signal may be pulse-width modulation or pulse code modulation.

Power switch driver circuit arrangements in accordance with the present invention will now be described with reference to the accompanying drawings, of which:-
Figure 1 shows a known form of power switch driver arrangement,
Figure 2 shows schematically a power switch driver arrangement in accordance with the invention,
Figure 3 shows fault identification codes utilised in the arrangement of Figure 2.
Figure 4 shows schematically a return or feedback path for the arrangement of Figure 2.
Figure 5 shows schematically a transmitter for the arrangement of Figure 2.
Figure 6 shows schematically a receiver for the arrangement of Figure 2, and
Figure 7 shows diagrammatically signal waveforms utilised in the arrangement of Figure 2, and
Figure 8 shows a state diagram illustrating the operation of part of the transmitter of Figure 5.

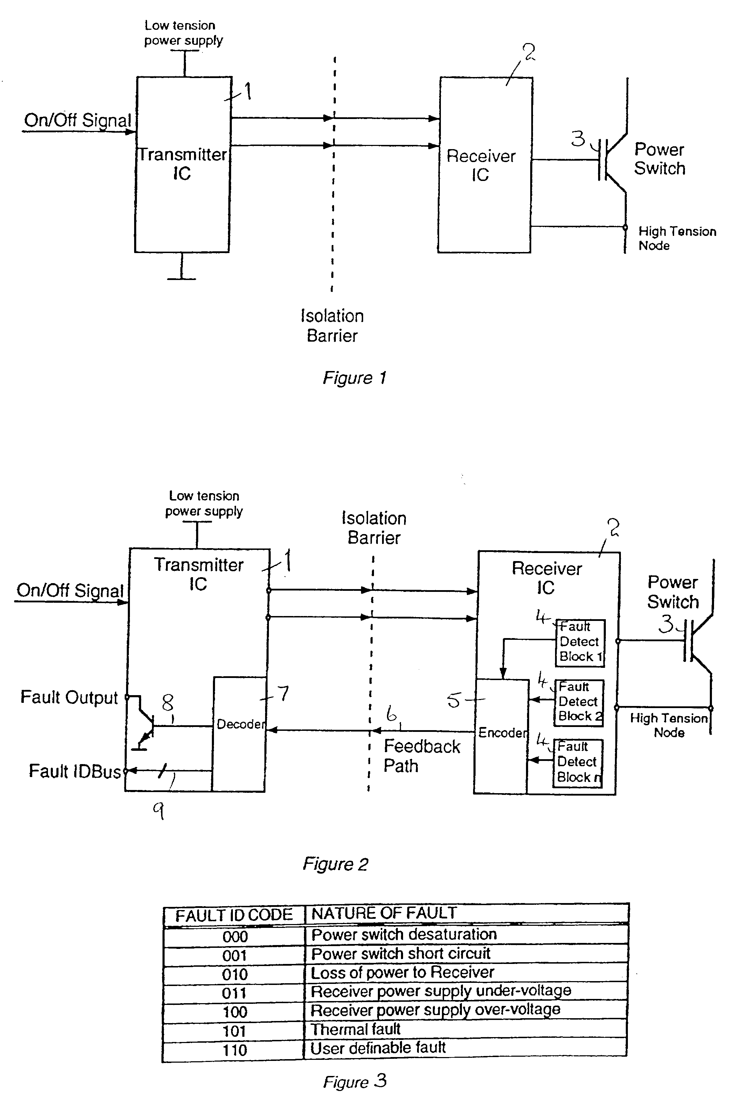

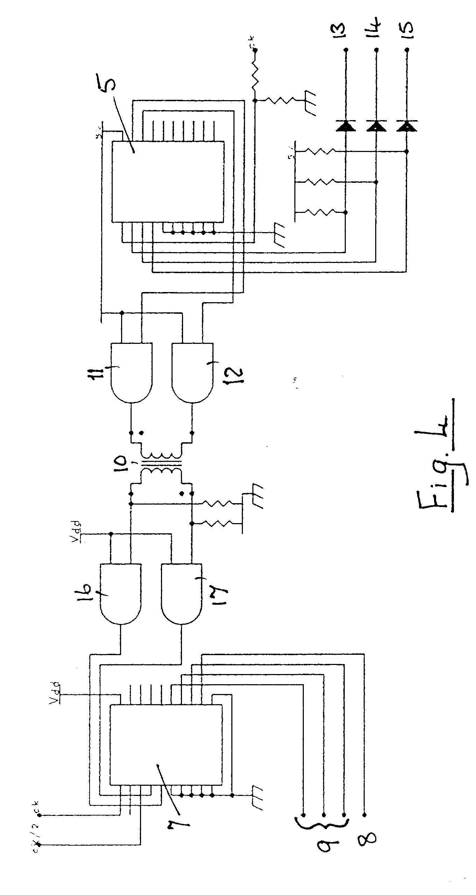

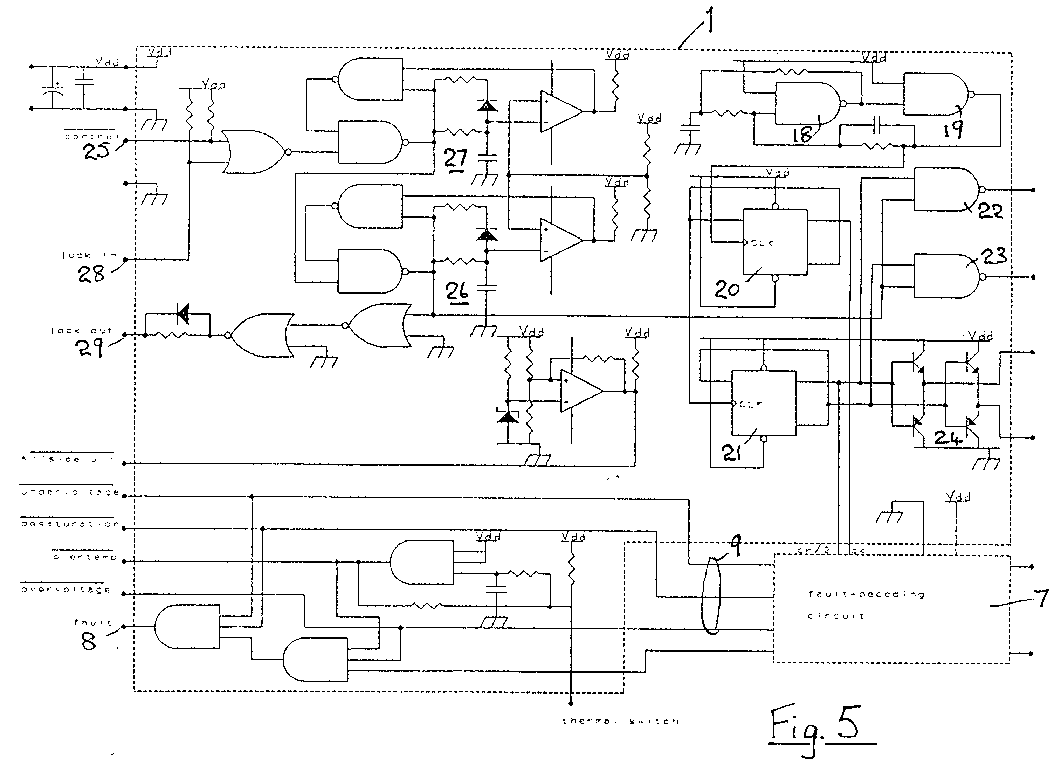

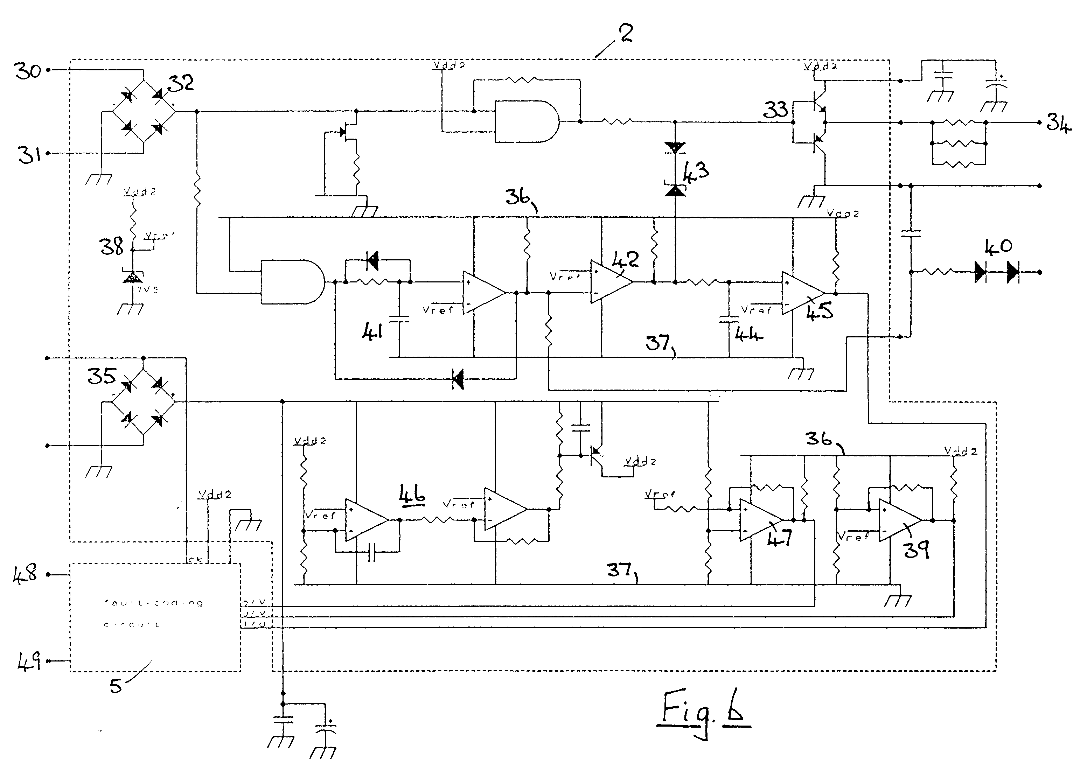

Referring to Figures 1 to 3 of the drawings, signals from a control circuit including a transmitter 1 are applied by way of an isolation device (not shown) which may be a pulse transformer, an optocoupler or similar device, across an isolation barrier to a receiver 2, which includes circuit means (not shown) for driving a power switch 3, which may for example be an insulated gate bipolar transistor (IGBT).

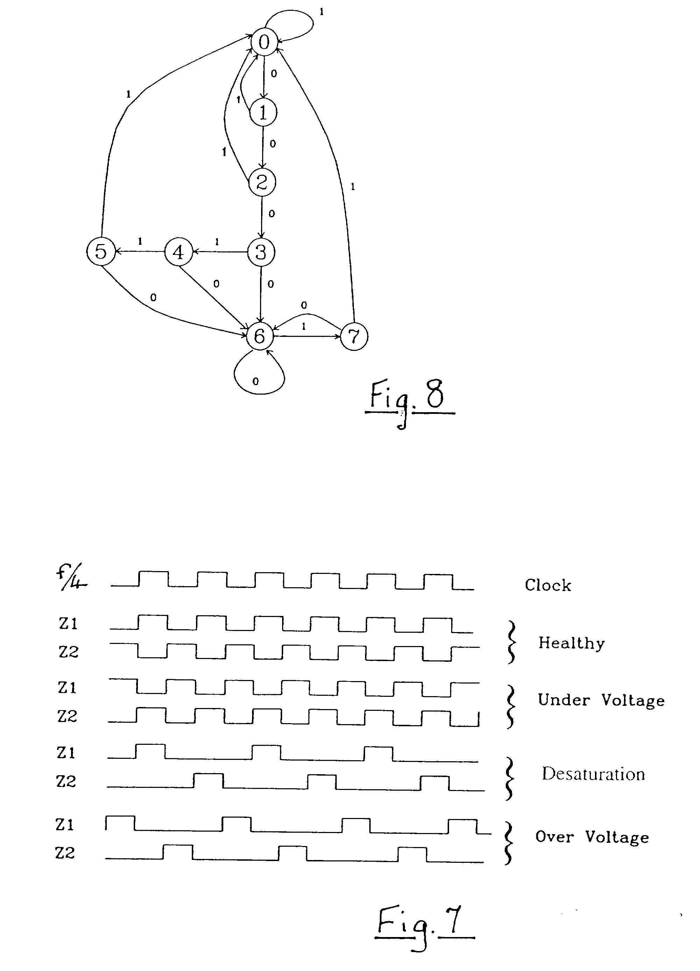

As shown in Figure 2, in accordance with the present invention the receiver 2 includes a plurality of circuit means 4 for detecting any of a plurality of predetermined faults which may occur in the control or the operation of the power switch 3, these faults being ascribed respective ones of a set of codes by an encoder 5, for example in accordance with the table given in Figure 3. These codes are transmitted over the return or feedback path 6 of the isolation device to a decoder 7 in the transmitter 1, for example by pulse width modulation or pulse code modulation of whatever form of signal the isolation device utilises.

The decoder 7 may provide two separate outputs, namely, a general opendrain/open collector fault indication by way of a transistor 8 and a fault identification code by way of a fault bus 9.

The fault encoding must be such that the necessary signals may be passed unambiguously across the isolation device with minimal delay. It must also be such that that failure of the encoder block 5 or of the integrity of the path 6 will be recognised and identified by the decoder 7. In other words the fault feedback arrangement must be fail-safe.

As indicated in Figure 4, the isolation device in the return or feedback path 6 may comprise a high frequency ferrite-cored transformer 10, the primary winding of which is energised by AND gates 11 and 12 under the control of the encoder 5 in dependence upon fault inputs 13, 14 and 15 from respective fault detect blocks 4. The secondary of the transformer 10 provides input signals for the decoder 7 by way of AND gates 16 and 17, any faults signalled resulting in outputs on the fault bus 9.

Referring now to Figure 5 a pair of NAND gates 18 and 19 are interconnected to form an oscillator the output frequency f of which is divided by two by flip-flop 20 and by two again by flip-flop 21, the frequency f/4 from the ouput of the flip-flop 21 being applied to another high frequency ferrite-cored transformer (not shown) by way of NAND gates 22 and 23 for transmission as a power switch "on" signal to a signalling input of the receiver 2, and to a power transformer (not shown), by way of a current amplifier 24, for energising the receiver 2. A signal for controlling the on/off state of the respective power switch 3, applied at an input terminal 25, under the control of an interlock signal at a terminal 28, is routed to enable the NAND gates 22 and 23 by way of minimum on/off time circuits 26 and 27. An "interlock out" signal made available at an output terminal 28 may be utilised to inhibit operation of a complementary power switch (not shown) while the power switch 3 is on.

As shown in Figure 6, the signals at a frequency of f/4 from the NAND gates 22 and 23 of the transmitter 1, which are received at terminals 30 and 31 of the receiver 2, are rectified by a bridge rectifier 32 and applied to the gate electrode of the power switch 3 by way of a current amplifier 33 and terminal 34. The energising signals at the frequency f/4, from the current amplifier 24 of the transmitter 1, are used both as a source of clock signals at the frequency f/4 for the encoder 5 and, by way of another bridge rectifier 35 and a voltage regulator circuit 46, as an energising source for the fault-detecting electronics, between a positive supply line 36 and an earth line 37. If in operation the voltage between the lines 36 and 37 falls below a predetermined value, set by a voltage reference circuit 38, the output of an amplifier 39 goes low, indicating the under-voltage condition to the encoder 5. This condition may be treated as the highest priority fault condition.

A fault condition of the power switch 3 referred to as desaturation is detected by way of a pair of high voltage diodes 40 connected to an output electrode of the power switch 3. When the power switch 3 is turned on by way of the circuits 32 to 34, a time interval set by a capacitor 41 is allowed to elapse before a detector amplifier 42 is enabled, in order to let the output electrode voltage to fall. If the electrode voltage is excessive after this time interval has elapsed then the output of the amplifier 42 goes low, pulling down the gate voltage of the power switch 3 by way of diodes 43 and the current amplifier 33. If the excessive electrode voltage still persists after a further time interval set by a capacitor 44 then the output of the following amplifier 45 will go low, signalling the desaturation condition to the encoder 5. This condition may be accorded the second highest fault priority.

If the output voltage of the bridge rectifier rises above a predetermined value, the output of an amplifier 47 is arranged to go low, signalling an over-voltage condition in the fault-detecting electronics. This over-voltage may be signalled as the lowest priority fault condition. If required a fault condition other than this over-voltage condition such as thermal overdrive and shut-down of the gate switching circuits, can be signalled as the lowest priority fault.

Although these fault indications can of course be modulated onto a carrier, derived say from the f/4 signal, in a number of different ways for transmission across the isolation barrier, in the present embodiment the highest priority fault of any occurring at any one time is utilised to modify the f/4 signal as indicated in Figure 7.

It will be appreciated that the f/4 signal, derived from the output of the flip-flop 21 in the transmitter 1, will be of the form of a pulse or square-wave. If all is operating within prescribed limits in the receiver 2 and its associated power switch 3 a "healthy" condition will be signalled by the encoding circuit 5, this condition being signalled by the return of this square waveform, as received by way of a terminal 48 and inverted by way of a terminal 49. The highest priority fault, the under-voltage condition, may be signalled by the inverse of these waveforms.

The next lower priority fault may be signalled by applying alternate ones of the f/4 pulses to the terminals 48 and 49, while the lowest priority fault may be signalled by applying alternate pulses of an inverted f/4 signal to the terminals 48 and 49, as indicated in Figure 7. It will be appreciated that with the pairs of signal waveforms indicated there will be no d.c. component of current flow in the primary winding of the transformer 10. It will be further appreciated that these pairs of waveforms may readily be obtained from the received f/4 signal utilising simple logic circuits, and that recognition at the decoder 7 of a fault being signalled can also be carried out utilising simple logic, since the waveforms are in synchronism with the f/4 signal, which acts as a clock signal.

Referring now to Figure 8, the recognition of the fault being signalled may for example be carried out utilising a so-called state machine (not shown) having eight states, which may be formed by three flip-flops connected in series, the eight states of the machine being designated in Figure 8 by the numbered circles O to 7. The machine is stepped from one state to the next, or not, in dependence upon the values of signals Z1 and Z2 received at the terminals 48 and 49 respectively.

During any clock signal interval a "healthy" signal, a logic "1", is indicated either if Z1 is high, Z2 is low and the clock signal is high or if Z1 is low, Z2 is high and the clock signal is low. This can be expressed alternatively as when Z1 and Z2 are in opposite states and Z1 is in phase with the clock. It will be appreciated that the "healthy" signal of Figure 7 will be indicated by a succession of logic "1"s.

On inspection of the signals shown in Figure 7 it will be appreciated that the undervoltage fault condition will give rise to an unbroken succession of logic "0"s, while the other two fault conditions will give rise repeatedly to three logic "0"s in succession followed by a single logic "1".

Starting from state 0, if a succession of logic "1"s are indicated, the machine stays in state 0, whereas if logic "0"s are indicated the machine is stepped to state 1, state 2, and so on. If the machine reaches state 3, in response to three "unhealthy" signals, this is taken as sufficient cause to activate a fault signal on terminal 8 (Figure 5). However, state 3 does not indicate which fault has occurred. If a fourth logic "0" is indicated then it can be assumed that an under voltage fault condition is being signalled. If the next indication is a logic "1", so that the machine goes to state 4, then a desaturation fault will be indicated if that logic "1" occurs when both Z1 and the clock signal are high and an overvoltage fault will be indicated if that logic "1" occurs when Z1 is high and the clock signal is low.

States 5 and 7 serve to prevent a following "healthy" signal from being instantly recognised as indicating a fault-free situation, two successive logic "1"s being required to get from a fault state to a fault-free state. This provides a measure of noise immunity. The states 3, 4, 5, 6 and 7 all indicate fault conditions, while states 0, 1 and 2 are taken as indicating a fault-free condition.

## Claims

1. A semiconductor power switch driver circuit arrangement in which a signal from a control circuit is arranged to be applied by way of isolation means to control the operation of a semiconductor power switch, and in which a return or feedback signal from said switch is arranged to be applied to said control circuit by way of said isolation means, wherein there are provided means which are associated with said switch and which are responsive to the occurrence of any one of a plurality of possible faults in the control or operation of said switch to identify said one of said plurality of faults with a respective one of a predetermined set of codes and to modulate said return signal such as to signal said respective one of said set of codes to said control circuit.

2. A circuit arrangement in accordance with Claim 1 wherein said isolation means comprises a pulse transformer.

3. A circuit arrangement in accordance with Claim 1 wherein said isolation means comprises first and second pulse transformers.

4. A circuit arrangement in accordance with Claim 1 wherein said isolation means comprises an optocoupler link.

5. A circuit arrangement in accordance with any preceding claim wherein said respective one of said set of codes is signalled by pulse-width modulation of said return signal.

6. A circuit arrangement in accordance with Claim 1, Claim 2 or Claim 3 wherein said respective one of said set of codes is signalled by pulse code modulation of said return signal.

7. A circuit arrangement in accordance with Claim 1 in which the signal from said control circuit is of substantially squarewave form, and said return signal under a fault condition comprises said squarewave signal altered selectively by inversion and/or gating in dependence upon the fault condition to be signalled.

8. A power switch driver circuit arrangement substantially as hereinbefore described with reference to Figures 2 and 3 of the accompanying drawing.

9. A power switch driver circuit arrangement substantially as hereinbefore described with reference to Figures 2 and 4 to 7 of the accompanying drawings.
